# EUROPÄISCHE PATENTSCHRIFT

(11) **EP 1 425 947 B1**
(45) Veröffentlichungstag und Bekanntmachung des Hinweises auf die Patenterteilung: **05.03.2008**
(21) Anmeldenummer: 02774301.2
(22) Anmeldetag: 04.09.2002
(51) Int. Cl.: H05K 3/00, B23K 26/38

(54) **VERFAHREN ZUM LASERBOHREN, INSBESONDERE UNTER VERWENDUNG EINER LOCHMASKE**
METHOD FOR LASER BEAM DRILLING WITH A PERFORATED MASK
PROCEDE DE PERCAGE PAR FAISCEAU LASER AU MOYEN D'UN MASQUE PERFORE

(30) Priorität: 13.09.2001 DE 10145184
(43) Veröffentlichungstag der Anmeldung: 09.06.2004
(73) Patentinhaber: Hitachi Via Mechanics, Ltd., Ebina-Shi Kanagawa 243-0488 (JP)
(72) Erfinder: DE STEUR, Hubert, B-9031 Drongen (BE); MÄRTEN, Otto, 63303 Dreielch (DE); WEHNER, Martin, 52134 Herzogenrath (DE); ROELANTS, Eddy, B-8000 Bruegge (BE); PAN, Wei, G1X 3Z3 Quebec, Sainte-Foy (CA); OVERMANN, Christian, 22045 Hamburg (DE); MAYER, Hans-Jürgen, 68519 Viernheim (DE)
(74) Vertreter: Beetz & Partner
(86) Internationale Anmeldenummer: PCT/DE2002/003266
(87) Internationale Veröffentlichungsnummer: WO 2003/026367

(56) Entgegenhaltungen:
- US-A- 4 328 410
- US-A- 4 959 119
- US-A- 5 910 255

## Beschreibung

Die Erfindung betrifft ein Verfahren zum Laserbohren von elektrischen Schaltungssubstraten, wobei ein Laserstrahl, vorzugsweise durch eine oberflächennahe Lochmaske, auf einen vorgesehenen Substratabschnitt gerichtet wird, um ein Loch mit einem vorgegebenen Lochdurchmesser zu bohren.

Die Verwendung von Lochmasken beim Bohren von Löchern, insbesondere auch von Sacklöchern, in Leiterplatten und vergleichbaren Substraten, die als Schaltungsträger dienen, ist seit langem bekannt (US 4,644,130A). Die in der Regel metallische Lochmaske besitzt Ausnehmungen, die durch ihre Konfiguration sowohl Position als auch Größe der zu bohrenden Löcher vorgeben (als sogenannte Conformal Mask). Die Metallschicht, welche die Maske bildet, ist dabei als sogenannte Proximity Mask unmittelbar mit der Oberfläche des Substrats verbunden oder mit geringem Abstand auf die Oberfläche aufgelegt.

In der US 5,585,019A ist ein Laserbearbeitungsverfahren unter Verwendung einer Vorrichtung beschrieben, bei der durch Gestaltung der Optik für den Laserstrahl sichergestellt wird, dass der Laserstrahl stets unter dem gleichen Winkel auf das Substrat auftrifft, ohne dass dieses selbst bewegt werden muss. Beim Bohren von Leiterplatten mit einer Lochmaske wird der Laser, üblicherweise ein CO2-Laser oder ein Laser mit vergleichbaren Eigenschaften, immer auf die gleiche Stelle über der Lochmaske gepulst (sogenanntes Punchen). Um dabei eine möglichst gleichmäßige Materialabtragung über dem gesamten Lochquerschnitt zu erzielen, wird für den Laserstrahl eine möglichst gleichmäßige Energieverteilung über den gesamten Lochdurchmesser angestrebt, während außerhalb des Lochrandes möglichst geringe Energieverluste erwünscht sind. Die Energieverteilung soll demnach möglichst ein Rechteckprofil mit steilen Flanken (top hat) aufweisen, um eine optimale Wirkung zu erzielen. Das Formen eines derartigen Laserstrahls ist aber sehr aufwendig. Es wird bisher entweder mit speziellen Optiken (z. B. diffraktiven Optiken) oder mit Blenden in einem abbildenden System im Strahlengang realisiert. Solche Optiken sind aber nur sehr aufwendig zu produzieren, während man mit Blenden einen großen Teil, oft über 50%, der Laserleistung verliert. Durch die dabei benötigte Abbildung mit festgelegtem Abbildungsverhältnis wird außerdem der Strahlengang sehr lang, und er erfordert sehr große Ablenkspiegel in der Ablenkeinheit.
US- A- 5910255 beschreibt ein Verfahren zum Laserbohren gemäß dem ersten Teil des Anspruchs 1.
Ziel der vorliegenden Erfindung ist es, ein Verfahren zum Bohren von Löchern, vorzugsweise unter Verwendung einer Lochmaske, anzugeben, bei dem auf spezielle Optiken und Blenden verzichtet werden kann und zugleich ein gleichmäßiger Materialabtrag im Loch bei möglichst geringem Verlust an Laserleistung erzielt wird.

Erfindungsgemäß wird dieses Ziel mit einem Verfahren der eingangs genannten Art dadurch erreicht, dass der Laserstrahl im Bereich des zu bohrenden Loches auf einer Kreisbahn bewegt wird, deren Mittelpunkt zentrisch zur Sollposition des jeweiligen Loches liegt und deren Durchmesser kleiner als der oder gleich dem Lochdurchmesser ist, und dass der Durchmesser des Laserstrahl-Flecks so bemessen ist, dass er während der Kreisbewegung des Laserstrahls den Mittelpunkt des Loches immer überdeckt.

Bei dem erfindungsgemäßen Verfahren wird also der Laserstrahl in einer sogenannten Wobbelbewegung auf einem Kreis innerhalb des Loches so geführt, dass bei jedem Umlauf zumindest die gesamte Querschnittsfläche des Loches überstrichen wird und dass der Strahlmittelpunkt mit der größten Energiedichte des Flecks im Bereich zwischen dem Mittelpunkt bzw. der Sollposition des Mittelpunktes und dem Rand umläuft, so dass die wirksame Energieverteilung der gewünschten Rechteckform angenähert wird.

Aufgrund der erfindungsgemäß erzielten Energieverteilung ist es grundsätzlich auch möglich, Löcher mit ausreichenden Randkonturen auch ohne Lochmaske zu bohren, insbesondere in organischen bzw. Dielektrikums-Schichten. Die bevorzugte Anwendung der Erfindung liegt jedoch bei der Bohrung von Löchern mit Hilfe von oberflächennahen Lochmasken, wobei als Lochmaske bevorzugt eine oberseitige Metallisierung einer (Mehrschicht-)Leiter-platte dient, wobei die Löcher in der Lochmaske ebenfalls durch Laserbohren erzeugt sein können. Im Fall der Verwendung einer Lochmaske besteht die erfindungsgemäße Lösung darin, daß der Laserstrahl im Bereich des jeweiligen Loches in der Lochmaske auf einer Kreisbahn bewegt wird, deren Mittelpunkt zentrisch zur Sollposition des jeweiligen Loches in der Maske liegt und deren Durchmesser kleiner als der oder gleich dem Lochdurchmesser ist, und daß der Durchmesser des Laserstrahl-Flecks während der Kreisbewegung des Laserstrahls den Mittelpunkt des Loches in der Maske, auch bei einem maximal zulässigen Positionsversatz der Lochmaske, immer überdeckt.

Um die Energieverteilung bei den einzelnen Umläufen des Laserstrahls möglichst gleichmäßig über den Umfang zu verteilen, wird der Laserstrahl vorzugsweise so geführt, daß er immer eine ganze Zahl von vollen Kreisumläufen ausführt. Die Einstellung der Pulsenergie des Lasers wird deshalb so gewählt, daß die für das Bohren des Loches erforderliche Gesamtenergie auf eine ganze Zahl von Kreisumläufen des Laserstrahls verteilt wird.

Vorzugsweise wird für das erfindungsgemäße Verfahren ein CO2-Laser mit hohen Pulsfrequenzen, also mit Wiederholfrequenzen von 20 kHz bis über 100 kHz, verwendet, so dass kein Zeitverlust gegenüber dem konventionellen Verfahren eintritt. Der Laser hat durch kleine Pulsbreiten in der Größenordnung von weniger als 500 ns, typischerweise aber ≤ 150 ns, bei diesen hohen Wiederholfrequenzen noch eine ausreichende Pulsleistung.

Die Erfindung wird nachfolgend an Ausführungsbeispielen anhand der Zeichnung näher erläutert. Es zeigt
Figur 1 die schematische Anordnung eines Lasers und eines Substrats mit Lochmaske zur Durchführung des erfindungsgemäßen Verfahrens;
Figur 2 einen Schnitt durch ein Substrat mit Lochmaske und einen Laserstrahl in schematischer Darstellung;
Figur 3 ein Loch einer Lochmaske in Draufsicht mit den schematisch dargestellten Fleck-Durchmessern einiger auftreffender Laserimpulse;
Figur 4 eine Darstellung entsprechend Figur 3, wobei die Lochmaske eine Positionstoleranz gegenüber ihrer Sollposition aufweist und
Figur 5 die Darstellung eines durch die Erfindung erzielbaren Energieverlaufs durch Simulation einzelner Strahlen.

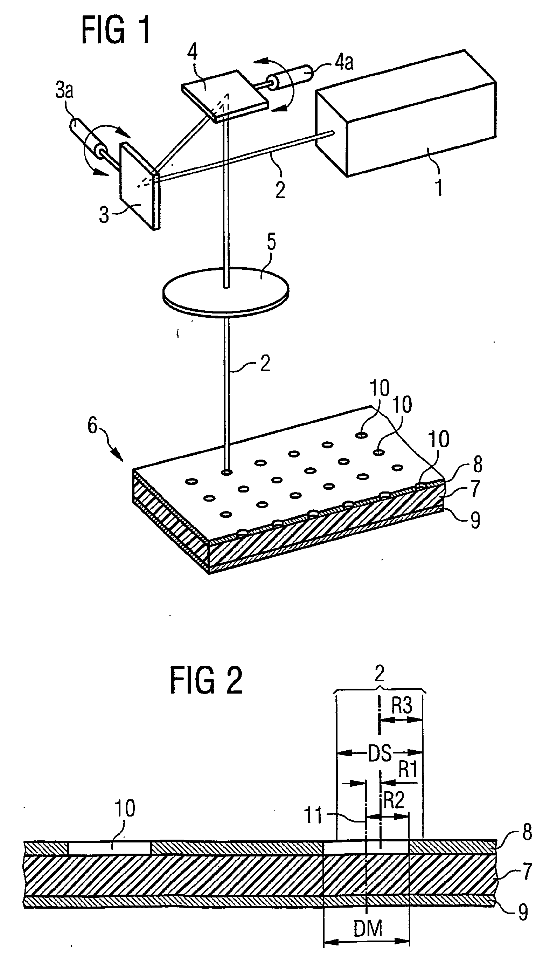

In Figur 1 ist grundsätzlich die Anordnung eines Lasers gezeigt, wie sie zum Bohren von Löchern mittels Lochmaske verwendet wird. Die Laserquelle 1 emittiert einen gepulsten Laserstrahl 2, der an einer Galvanometereinheit mit zwei um unterschiedliche Achsen schwenkbaren Spiegeln 3 und 4 abgelenkt und dann über ein Abbildungssystem, im vorliegenden Beispiel eine telezentrische Linse 5, so fokussiert wird, dass der Strahl 2 mit einer vorgegebenen Fleckweite auf ein Substrat bzw. eine Leiterplatte 6 auftrifft. Die Leiterplatte besitzt eine Dielektrikumsschicht 7, die zwischen zwei Metallschichten 8 und 9 liegt. Dabei dient die obere Metallschicht 8 als Lochmaske; sie ist zu diesem Zweck mit Löchern 10 versehen, welche zuvor auf bekannte Weise, beispielsweise auch durch Laserbohren oder durch Ätzen, erzeugt wurden. Anstelle der mit der Dielektrikumsschicht 7 fest verbundenen Metallschicht 8 könnte aber auch eine lose aufgelegte Lochmaske in Form einer Folie oder dergleichen Verwendung finden. Durch entsprechende Steuerung der Spiegel 3 und 4 mit Hilfe von sehr schnellen Galvanometern 3a bzw. 4a wird der Laserstrahl 2 jeweils auf eines der Löcher 10 gelenkt, um in der Dielektrikumsschicht 7 ein Loch mit dem gleichen Durchmesser zu erzeugen. Vorzugsweise werden auf diese Weise Sacklöcher gebohrt, die an der unteren Metallschicht 9 enden.

Da die Energieverteilung des Laserstrahls nicht gleichmäßig über den gesamten Fleckdurchmesser verteilt ist, wird erfindungsgemäß der Laserstrahl im Bereich des jeweiligen Loches 10 "gewobbelt". Das heißt, der gepulste Strahl wird sehr schnell in einem Kreis bewegt, dessen Mittelpunkt M mit der Mittelachse 11 des Loches in dessen Sollposition übereinstimmt, wobei der Radius R1 des Kreises im vorliegenden Fall kleiner ist als der Radius R2 des Loches 10. Der Fleckdurchmesser DS liegt in der Regel in der gleichen Größenordnung wie der Lochdurchmesser DM (= 2 X R2) der Lochmaske, wobei er auch etwa 10 - 20 % größer oder kleiner als dieser sein kann. Bei Lochdurchmessern von 200 µm kann der Fleckdurchmesser also beispielsweise zwischen 180 und 220 µm liegen; bei kleineren Lochdurchmessern wird der Fleckdurchmesser eher an der unteren Grenze dieses Bereiches (180 µm) oder auch darunter liegen. Der Kreisdurchmesser für das "Wobbeln" (Circle-Punching) des Laserstrahls kann nun so gewählt werden, dass eine möglichst rechteckige Energieverteilung (top hat) erzeugt wird, die für die entsprechende Lochmaske optimal ist. Auch Positionstoleranzen der Lochmasken können durch das Variieren des Kreisdurchmessers kompensiert werden. Es wird in der Regel immer ein voller Kreis mit dem Laserstrahl gefahren, d. h., dass die Anzahl der notwendigen Pulse für die gewünschte Lochtiefe und der Kreisdurchmesser R1 den Abstand von einem Puls zum nächsten auf der Kreisbahn bestimmen.

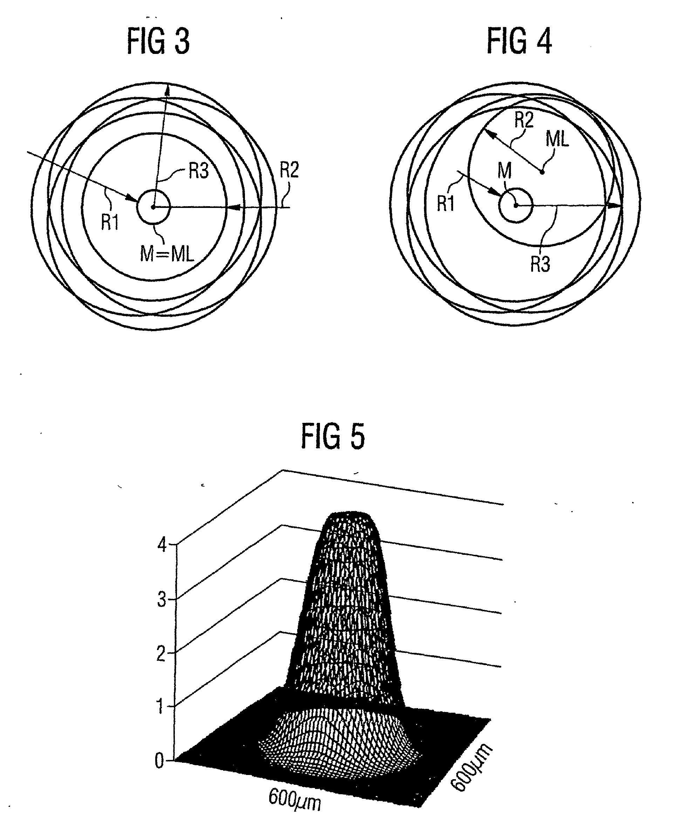

Figur 3 zeigt ein Beispiel für die Überlagerung der verschiedenen Laserimpulse über dem Loch einer Lochmaske, und zwar für den Fall, dass die Lochmaske genau ihre Sollposition besitzt. Das Loch der Lochmaske ist mit dem Mittelpunkt ML und dem Radius R2 gekennzeichnet; es besitzt im Beispiel einen Durchmesser von 120 µm, also R2=60 µm. Der Laserstrahl mit einem Fleckdurchmesser von 180 µm, d. h. mit einem Radius R3=90 µm wird in einem Kreis mit dem Radius R1=25 µm bewegt. Gezeigt sind in Figur 3 nur die Positionen von vier Laserpulsen, die einander überlagern. Die tatsächliche Anzahl der Pulse hängt davon ab, wie viel Energie zum Bohren des gesamten Loches in dem Substrat erforderlich ist.

Figur 4 zeigt ein zweites Beispiel, wobei in Abwandlung gegenüber Figur 3 angenommen ist, dass das Loch 10 mit seinem Mitelpunkt ML der Lochmaske 8 gegenüber dem Mittelpunkt M der Sollposition einen Positionsversatz von 25 µm in x-Richtung und von 25 µm in y-Richtung aufweist. Die Radien R1 für den Wobbelkreis, R2 für das Loch der Maske und R3 für den Laserfleck besitzen die gleiche Größe wie in Figur 3. Auch in diesem Fall kann trotz des Versatzes der Lochmaske eine weitgehend gleichmäßige Energieverteilung zum Bohren des Loches erzielt werden.

In Figur 5 ist eine Simulation einer Energieverteilung gezeigt, wie sie mit dem erfindungsgemäßen Verfahren erzielbar ist. Dabei sind elf einzelne Strahlen mit einem Fleckdurchmessern von 200 µm gezeigt, die in einem Doppelkreis von 150 µm Durchmesser bewegt werden. Der Bildausschnitt beträgt in diesem Fall 600 µm x 600 µm.

Bei dem erfindungsgemäßen Verfahren kann also durch Kombination einer schnellen Ansteuerung der Galvospiegel und eines gütegeschalteten CO2-Lasers mit hoher Pulsfrequenz, eine sehr gute, annähernd rechteckförmige Energieverteilung der wirksamen Laserenergie erreicht werden, wobei relativ kleine Ablenkspiegel verwendet werden können. Hiermit kann ein hoher Durchsatz erreicht werden; zugleich werden auch Positionstoleranzen aufgefangen.

Die Umlaufgeschwindigkeit des Laserstrahls hängt ab vom Durchmesser des Loches, von der Pulsfrequenz und von der jeweils benötigten Anzahl an Pulsen. So wurden beispielsweise in einem Dielektrikum aus RCC (Resin Coated Copper) Löcher von etwa 150 µm Durchmesser mit einem GEM-100-Laser des Herstellers COHERENT gebohrt. Dabei wurde der Laserstrahl mit 100 kHz Wiederholfrequenz in einem Wobbel-Durchmesser von 100 µm geführt. Es ergab sich, daß zum Bohren der Löcher jeweils 10 Pulse erforderlich waren, woraus sich eine Umlaufgeschwindigkeit des Laserstrahls von 3 m/s ergab.

Für das Bohren der gleichen Löcher in FR4 waren 40 Pulse bei 60 kHz erforderlich, woraus sich eine Umlaufgeschwindigkeit des Laserstrahls von etwa 470 mm/s ergab.

## Patentansprüche

1. Verfahren zum Laserbohren von elektrischen Schaltungssubstraten (6), wobei ein Laserstrahl (2) auf einen zu bohrenden Substratabschnitt gerichtet wird,
wobei der Laserstrahl (2) im Bereich des zu bohrenden Loches (10) auf einer Kreisbahn bewegt wird, deren Mittelpunkt (M) zentrisch zur Sollposition (11) des zu bohrenden Loches (10) liegt und deren Durchmesser (DS) kleiner als der oder gleich dem Lochdurchmesser (DM) ist,
**dadurch gekennzeichnet, dass** der Durchmesser (DS) des Laserstrahl-Flecks während der Kreisbewegung des Laserstrahls (2) den Mittelpunkt (ML) des Loches immer überdeckt.

2. Verfahren nach Anspruch 1, wobei der Laserstrahl durch eine oberflächennahe Lochmaske (8) mit einem vorgegebenen Lochdurchmesser (DM) auf den zu bohrenden Substratabschnitt gerichtet wird,
**dadurch gekennzeichnet , daß** der Laserstrahl (2) im Bereich des jeweiligen Loches (10) in der Lochmaske (8) auf einer Kreisbahn bewegt wird, deren Mittelpunkt (M) zentrisch zur Sollposition (11) des jeweils zu bohrenden Loches (10) liegt und deren Durchmesser (DS) kleiner ist als der oder gleich ist dem Lochdurchmesser (DM), und
daß der Durchmesser (DS) des Laserstrahl-Flecks während der Kreisbewegung des Laserstrahls (2) den Mittelpunkt (ML) des Loches (10) in der Lochmaske (8) auch bei einem maximal zulässigen Positionsversatz der Lochmaske, immer überdeckt.

3. Verfahren nach Anspruch 1 oder 2,
**dadurch gekennzeichnet,**
**dass** der Kreisdurchmesser (2 x R1) mindestens einem Achtel des Lochdurchmessers (2 x R2) und höchstens dem Lochdurchmesser entspricht.

4. Verfahren nach Anspruch 3,
**dadurch gekennzeichnet,**
**dass** der Kreisdurchmesser (2 x R1) zwischen einem Viertel und der Hälfte des Lochdurchmessers (2 x R2) beträgt.

5. Verfahren nach einem der Ansprüche 1 bis 4,
**dadurch gekennzeichnet,**
**dass** der Fleckdurchmesser (DS) des Laserstrahls um bis zu 20 %, vorzugsweise um etwa 10 %, größer oder kleiner als der Lochdurchmesser (DM) ist.

6. Verfahren nach einem der Ansprüche 1 bis 5,
**dadurch gekennzeichnet,**
**dass** der Laserstrahl (2) durch einen CO2-Laser (1) erzeugt wird.

7. Verfahren nach Anspruch 6,
**dadurch gekennzeichnet,**
**dass** der Laser eine Wiederholfrequenz von mindestens 20 KHz, vorzugsweise von etwa 100 KHz ± 10 %, aufweist.

8. Verfahren nach einem der Ansprüche 1 bis 7,
**dadurch gekennzeichnet,**
**dass** der Laser mit einer Pulsbreite von < 500 ns, vorzugsweise ≤ 150 ns, verwendet wird.

9. Verfahren nach einem der Ansprüche 2 bis 8,
**dadurch gekennzeichnet,**
**dass** die Lochmaske (8) durch eine fest auf der Oberfläche der Leiterplatte (6) haftende Metallschicht gebildet wird.

10. Verfahren nach einem der Ansprüche 2 bis 8,
**dadurch gekennzeichnet,**
**dass** die Lochmaske durch eine lose auf der Leiterplatte angeordnete Metallfolie gebildet wird.

## Claims

1. Method for laser beam drilling of electric circuit substrates (6), in which a laser beam (2) is directed onto a substrate section to be drilled,
in which the laser beam (2) is moved in a circular path in the area of the hole to be drilled (20), the centre (M) of which is central to the theoretical position (11) of the hole to be drilled (10) and the diameter of which (DS) is smaller than or the same as the diameter of the hole (DM),
**characterised in that**
the diameter (DS) of the spot of the laser beam always covers the centre (ML) of the hole during the circular movement of the laser beam (2).

2. Method according to claim 1, in which the laser beam is directed onto the
substrate section to be drilled through a perforated mask (8) with a preset diameter of the hole (DM), which is close to the surface,
**characterised in that** the laser beam (2) is moved in a circular path in the area of the relevant hole (10) in the perforated mask (8), the centre of which (M) is central to the theoretical position (11) of the relevant hole to be drilled (10) and the diameter of which (DS) is smaller than or the same as the diameter of the hole (DM), and the diameter (DS) of the spot of the laser beam always covers the centre (ML) of the hole (10) in the perforated mask (8), even when the perforated mask is in the maximum offset position allowed.

3. Method according to claim 1 or 2,
**characterised in that**
the diameter of the circle (2 x R1) corresponds to at least one eighth of the diameter of the hole (2 x R2) and at most the diameter of the hole.

4. Method according to claim 3,
**characterised in that**
the diameter of the circle (2 x R1) amounts to between a quarter and a half of the diameter of the hole (2 x R2).

5. Method according to one of claims 1 to 4,
**characterised in that**
the diameter of the spot (DS) of the laser beam is larger or smaller than the diameter of the hole (DM) by up to 20%, preferably by about 10%.

6. Method according to one of claims 1 to 5,
**characterised in that**
the laser beam (2) is produced by a CO2 laser (1).

7. Method according to claim 6,
**characterised in that**
the laser has a repeat frequency of at least 20 KHz, preferably of about 100 KHz ± 10%.

8. Method according to one of claims 1 to 7,
**characterised in that**
the laser is used with a pulse width of < 500 ns, preferably ≤ 150 ns.

9. Method according to one of claims 2 to 8,
**characterised in that**
the perforated mask (8) is formed by a metal layer, which adheres firmly to the surface of the printed circuit (6).

10. Method according to one of claims 2 to 8,
**characterised in that**
the perforated mask is formed by a metal foil, which is arranged loosely on the printed circuit.

## Revendications

1. Procédé de forage laser de cartes de circuits imprimés électriques (6), dans lequel un rayon laser (2) est dirigé sur une section du substrat à forer,
Dans lequel le rayon laser (2) est mû dans la zone du trou à forer (10) sur une voie circulaire, dont le milieu (M) se situe au centre de la position de consigne (11) du trou à forer (10) et dont le diamètre (DS) est inférieur ou égal au diamètre du trou (DM),
**caractérisé en ce que**
le diamètre (DS) du spot du rayon laser pendant le mouvement circulaire du rayon laser (2) recouvre toujours le milieu (ML) du trou.

2. Procédé selon la revendication 1, dans lequel le rayon laser est dirigé sur la section du substrat à forer par le biais d'un masque perforé (8) proche de la surface, ayant un diamètre de trou prédéterminé (DM),
**caractérisé en ce que**
le rayon laser (2) est mû dans la région du trou respectif (10) dans le masque perforé (8) sur une voie circulaire, dont le milieu (M) se situe au centre de la position de consigne (11) du trou à forer (10) et dont le diamètre (DS) est inférieur ou égal au diamètre du trou (DM), et
**en ce que** le diamètre (DS) du spot du rayon laser pendant le mouvement circulaire du rayon laser (2) recouvre toujours le milieu (ML) du trou (10) dans le masque perforé (8), également en cas de décalage de position maximal admissible du masque perforé.

3. Procédé selon la revendication 1 ou 2,
**caractérisé en ce que**
le diamètre du cercle (2 x R1) correspond à au moins un huitième du diamètre du trou (2 x R2) et correspond au maximum au diamètre du trou.

4. Procédé selon la revendication 3,
**caractérisé en ce que**
le diamètre du cercle (2 x R1) atteint entre un quart et la moitié du diamètre du trou (2 x R2).

5. Procédé selon l'une des revendications 1 à 4,
**caractérisé en ce que**
le diamètre du spot (DS) du rayon laser est supérieur ou inférieur au diamètre du trou (DM) d'un pourcentage allant jusqu'à 20 %, de préférence jusqu'à environ 10 %.

6. Procédé selon l'une des revendications 1 à 5,
**caractérisé en ce que**
le rayon laser (2) est produit par un laser CO₂ (1).

7. Procédé selon la revendication 6,
**caractérisé en ce que**
le laser présente une fréquence de répétition d'au moins 20 KHz, de préférence d'environ 100 KHz ± 10 %.

8. Procédé selon l'une quelconque des revendications 1 à 7,
**caractérisé en ce que**
le laser est utilisé avec une largeur d'impulsion de < 500 ns, de préférence ≤ 150 ns.

9. Procédé selon l'une des revendications 2 à 8,
**caractérisé en ce que**
le masque perforé (8) est formé par une couche métallique adhérant solidement sur la surface de la carte de circuit imprimé (6).

10. Procédé selon l'une des revendications 2 à 8,
**caractérisé en ce que**
le masque perforé est formé par une feuille métallique disposée de manière lâche sur la carte de circuit imprimé.
